# FASCICULE DE BREVET EUROPEEN

(11) **EP 2 138 457 B1**
(45) Date de publication et mention de la délivrance du brevet: **27.02.2019**
(21) Numéro de dépôt: 09163710.8
(22) Date de dépôt: 25.06.2009
(51) Int. Cl.: H01L 21/768, B01J 23/745, B01J 23/75, B01J 37/12, C01B 32/162, H01L 23/532, B82Y 30/00, B82Y 40/00, B01J 37/02

(54) **Procédé d'obtention de tapis de nanotubes de carbone sur substrat conducteur ou semi-conducteur**
Verfahren zur Herstellung einer Matte aus Kohlenstoffnanoröhren auf einem Leiter- oder Halbleitersubstrat
Method for obtaining a carpet of carbon nanotubes on a conductor or semi-conductor substrate

(30) Priorité: 27.06.2008 FR 0854326
(43) Date de publication de la demande: 30.12.2009
(73) Titulaire: Commissariat à l'Énergie Atomique et aux Énergies Alternatives, 75015 Paris (FR)
(72) Inventeur: Dijon, Jean, 38800 Champagnier (FR); Fournier, Adeline, 38120 Mont Saint Martin (FR)
(74) Mandataire: Augarde, Eric

(56) Documents cités:
- WO-A-00/30141
- WO-A-2005/025734
- US-A1- 2003 179 559
- US-A1- 2005 215 049
- QIAN WEN ET AL: "Oxygen-assisted synthesis of SWNTs from methane decomposition" NANOTECHNOLOGY, IOP, BRISTOL, GB, vol. 18, no. 21, 30 mai 2007 (2007-05-30), page 215610, XP020119198 ISSN: 0957-4484

## Description

### DOMAINE TECHNIQUE

La présente invention concerne le domaine des nanotubes de carbone. Elle trouve notamment application dans la réalisation de vias dans les circuits intégrés.

### ÉTAT DE LA TECHNIQUE ANTÉRIEURE

L'utilisation de nanotubes pour l'interconnexion de différentes couches d'un circuit intégré a récemment fait l'objet d'importantes recherches. Leurs excellentes propriétés conductrices, leur stabilité électrique et thermique font en effet des nanotubes de carbone (NTC) d'excellents candidats pour la réalisation de vias de très faible diamètre. Un exemple de via réalisé à partir de NTC est décrit dans la demande WO 01/61753.

Une caractéristique essentielle d'un via est sa résistance électrique qui, lorsqu'il est réalisé à base de NTC, est fonction de la densité surfacique des nanotubes. En pratique, le tapis de NTC dans le via doit atteindre une densité de nanotubes de l'ordre de 10¹¹ à 10¹³ cm⁻² pour présenter une résistance électrique comparable à celle du cuivre. Ces nanotubes doivent être connectés au substrat semi-conducteur ou à une couche conductrice déposée au fond du via.

Les procédés de croissance actuels permettant d'obtenir de telles densités de NTC supposent tous de partir d'un oxyde comme l'alumine ou le MgO. Par exemple, l'article de G. Zhong et al intitulé « Growth kinetics of 0.5cm vertically aligned single-walled carbon nanotubes », publié dans Chem. B. (Letter) ; 2007 ; 111(8) ; 1907-1910, décrit un procédé de croissance de tapis de NTC simples parois (SWNTC) à partir d'une couche d'alumine. Plus précisément, le substrat de Si est préalablement recouvert d'un sandwich catalytique Al₂O₃(0.5nm)/Fe(0,5nm)/Al₂O₃ (≥ 5nm) par pulvérisation cathodique avant de faire croître les NTC par dépôt chimique en phase vapeur assisté par plasma (PECVD). Un prétraitement sous atmosphère réductrice pendant la phase de montée en température de l'échantillon est nécessaire pour former les nanoparticules de fer qui initieront la croissance des nanotubes.

La présence d'une couche d'oxyde rend les procédés de croissance précités impropres à la réalisation d'interconnexions dans un circuit intégré.

On notera que l'art antérieur comporte les documents suivants : WO 00/30141 et US 2003/0179559.

Le but de la présente invention est par conséquent de proposer un procédé d'obtention de tapis de nanotubes de carbone à haute densité sur un matériau conducteur ou semi-conducteur, sans dépôt préalable d'une couche d'oxyde.

### EXPOSÉ DE L'INVENTION

La présente invention est définie par un procédé d'obtention d'un tapis de nanotubes de carbone sur un substrat conducteur ou semi-conducteur comprenant les étapes suivantes :
- dépôt d'un complexe catalytique comprenant au moins une couche métallique, sur ledit substrat, la couche métallique étant composée de fer et déposée sur une couche de silicium amorphe, la couche de silicium amorphe étant déposée sur le substrat, le substrat étant du nitrure de titane ou de nitrure de tantale ;
- traitement oxydant de ladite couche métallique au moyen d'un plasma ou d'une succession de plasma;
- croissance de nanotubes de carbone à partir de la couche métallique ainsi oxydée.

Le traitement oxydant est de préférence réalisé au moyen d'une oxydation par un plasma ou par une succession de plasmas.

Selon une variante, le traitement oxydant comprend une première étape d'oxydation à l'aide d'un premier plasma à une première énergie et une première pression et une seconde étape d'oxydation à l'aide d'un second plasma à une seconde énergie plus faible que ladite première énergie et à une seconde pression plus élevée que ladite première pression.

L'oxydation par plasma peut être effectuée à température ambiante.

Le complexe catalytique comprend avantageusement une couche métallique déposée sur une couche de silicium amorphe, la couche de silicium amorphe étant déposée sur le substrat conducteur.

Le substrat peut notamment être du nitrure de titane ou du nitrure de tantale, ladite couche métallique peut être constituée de fer ou de cobalt.

L'invention concerne également un procédé de réalisation d'un via destiné à interconnecter une première et une seconde couches conductrices, comprenant les étapes suivantes :
- dépôt d'une barrière de diffusion sur la première couche conductrice;
- formation d'un complexe catalytique comprenant une première couche de silicium amorphe et une couche métallique composée de fer sur la barrière de diffusion, au fond du via ;
- traitement oxydant de ladite couche métallique au moyen d'un plasma ou d'une succession de plasmas;
- croissance de nanotubes de carbone à partir de la couche métallique ainsi oxydée, le temps de croissance étant déterminé de manière à ce que la longueur des nanotubes soit supérieure à la profondeur du via.

Le procédé de réalisation comprend en outre avantageusement les étapes suivantes :
- dépôt de la couche de silicium amorphe sur la barrière de diffusion;
- dépôt d'une couche diélectrique sur la couche de silicium amorphe, puis dépôt de la seconde couche conductrice sur la couche diélectrique ;
- dépôt d'un masque de gravure et gravure d'un trou de via jusqu'à la couche de silicium amorphe.

L'étape de gravure du trou de via peut être suivie d'un dépôt de la couche métallique et d'une élimination du masque, le complexe catalytique étant ainsi localisé au fond du trou de via.

Alternativement, l'étape de gravure du trou de via peut être suivie d'une élimination du masque et d'un dépôt de la couche métallique, le complexe catalytique étant ainsi localisé au fond du trou de via et la seconde couche conductrice étant recouverte de ladite couche métallique.

Selon une variante de réalisation le procédé de réalisation d'un via comprend les étapes suivantes :
- dépôt d'une couche diélectrique sur la barrière de diffusion, puis dépôt de la seconde couche conductrice sur la couche diélectrique ;
- dépôt d'un masque de gravure, gravure d'un trou de via jusqu'à la couche de silicium amorphe et élimination du masque ;
- dépôt de la couche métallique, puis polissage mécano-chimique de manière à éliminer le complexe catalytique présent sur la seconde couche conductrice, le complexe catalytique étant ainsi localisé au fond du trou de via.

Le dépôt de la couche métallique est de préférence réalisé au moyen d'une pulvérisation par faisceau d'ions.

Le traitement oxydant est avantageusement réalisé au moyen d'une oxydation par un plasma ou une succession de plasmas, à température ambiante.

### BRÈVE DESCRIPTION DES DESSINS

D'autres caractéristiques et avantages de l'invention apparaîtront à la lecture d'un mode de réalisation préférentiel de l'invention fait en référence aux figures jointes parmi lesquelles :
La Figure 1 montre un tapis de nanotubes obtenu sur un premier type de substrat au moyen d'un exemple de procédé selon l'invention ;
La Figure 2 montre un tapis de nanotubes obtenu sur ce premier type de substrat au moyen d'un procédé connu de l'état de la technique ;
La Figure 3 montre un tapis de nanotubes obtenu sur un second type de substrat au moyen d'un autre exemple de procédé selon l'invention ;
La Figure 4 montre l'absence de tapis de nanotubes sur ce second type de substrat en utilisant un procédé connu de l'état de la technique ;
Les Figures 5A à 5H illustrent un procédé de réalisation d'un via selon un mode de réalisation de l'invention ;
Les Figures 5F' à 5H' illustrent certaines étapes d'un procédé de réalisation d'un via selon une première variante du procédé illustré en Figures 5A à 5H ;

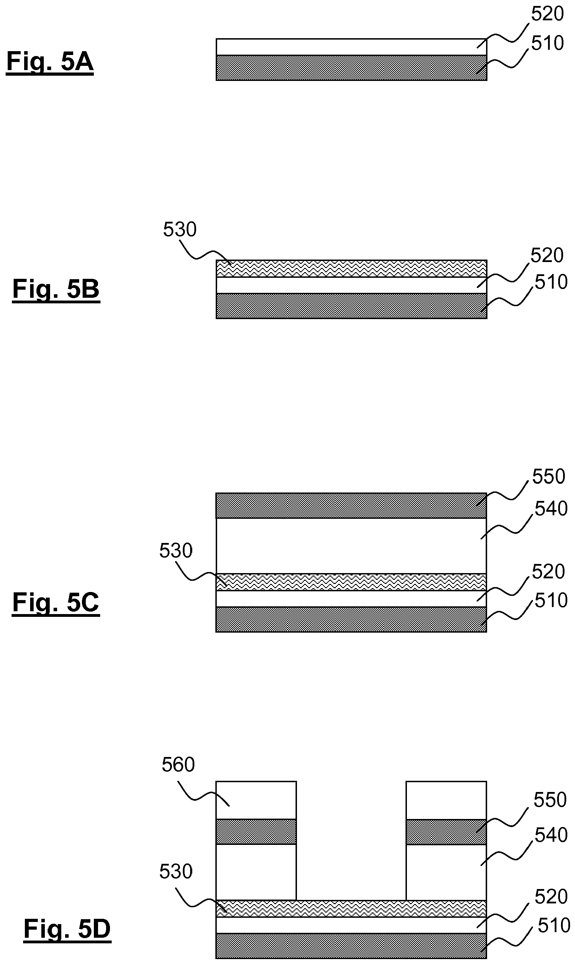

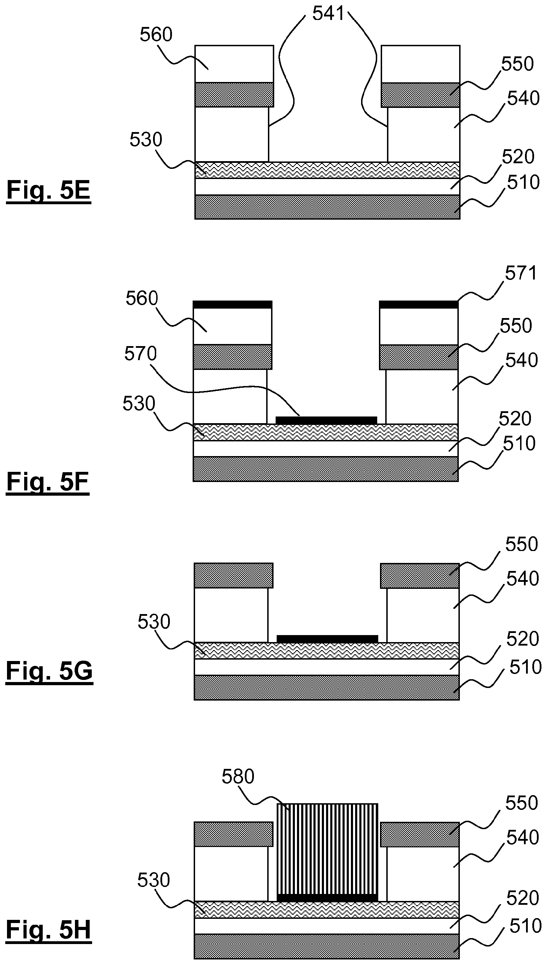

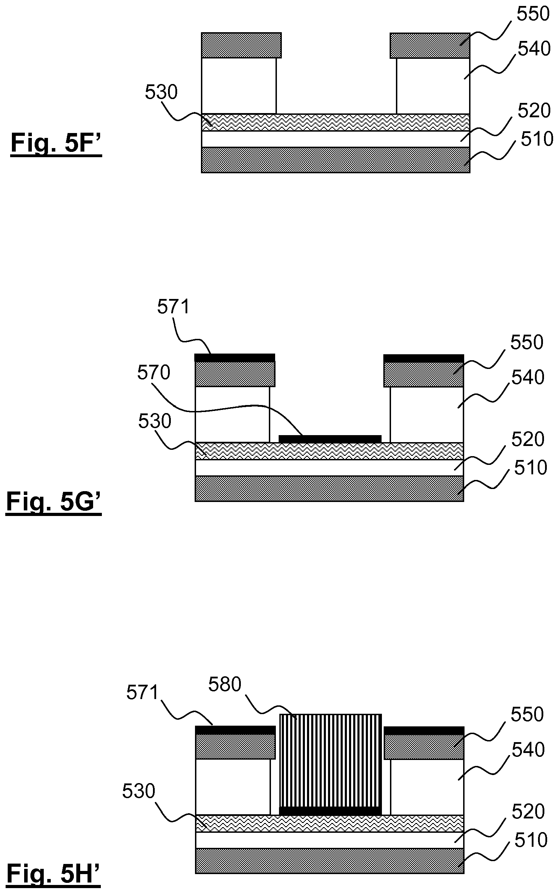

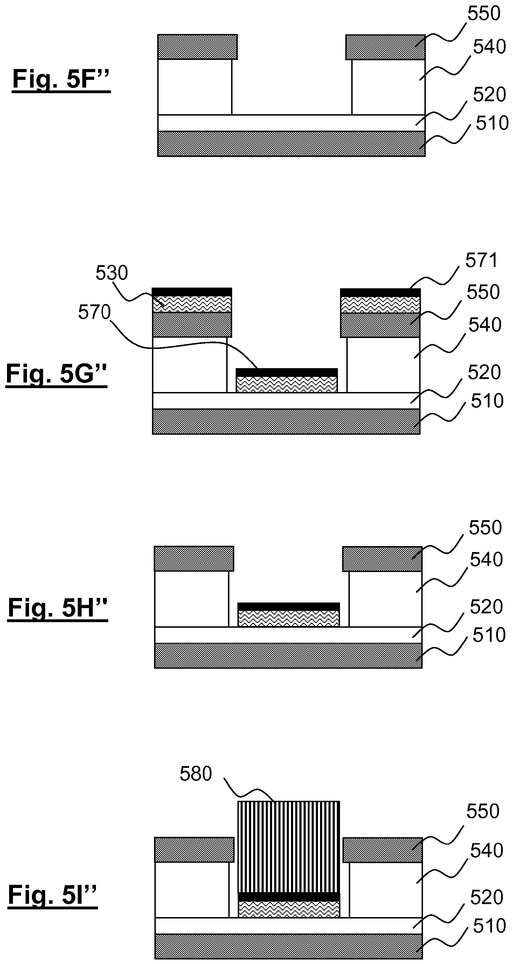

Les Figures 5F" à 5I" illustrent certaines étapes d'un procédé de réalisation d'un via selon une seconde variante du procédé illustré en Figures 5A à 5H.

### EXPOSÉ DÉTAILLÉ DE MODES DE RÉALISATION PARTICULIERS

Le procédé de croissance des NTC selon l'invention part de la constatation surprenante qu'un traitement préalable sous atmosphère oxydante du catalyseur métallique permet d'initier la croissance des nanotubes.

Plus précisément, on dépose tout d'abord sur le substrat conducteur ou semi-conducteur une couche métallique composée de fer servant de catalyseur de croissance. On entend ici par substrat un substrat pour la croissance des nanotubes. En particulier, une couche d'un matériau conducteur ou semi-conducteur déposée sur un substrat quelconque, au sens général, pourra être elle-même qualifiée de substrat conducteur ou semi-conducteur.

On effectue ensuite un traitement de l'échantillon sous atmosphère oxydante avant de faire croître les nanotubes.

Une couche de silicium amorphe est déposée sur le substrat, préalablement au dépôt de la couche de catalyseur métallique. Le substrat est un matériau utilisé comme barrière de diffusion, c'est-à-dire le nitrure de titane (TiN) ou le nitrure de tantale (TaN), et le système catalytique est une bicouche composée d'une couche de silicium amorphe, de quelques nanomètres d'épaisseur, de préférence de 1 à 10 nm, et d'une couche métallique composée de fer de l'ordre du nanomètre à quelques nanomètres, de préférence de 0,5 à 5 nm.

La couche de silicium amorphe permet d'améliorer grandement la croissance des NTC, tant en termes de densité (gain d'un facteur 10) que de diminution de diamètre (gain d'un facteur 2). L'épaisseur de la couche de silicium amorphe est avantageusement comprise entre 1 et 10 nm.

Le traitement oxydant est un traitement par plasma oxydant ou une succession de plasmas oxydants dans des compositions et/ou des conditions différentes telles qu'énergie, pression ou température. Lorsque deux plasmas successifs sont utilisés, le premier plasma peut être un plasma à forte énergie et/ou plus faible pression que le second. Par exemple, on pourra utiliser d'abord un plasma à forte énergie, de préférence comprise entre 0,1 et 1 W/cm², et faible pression, de préférence comprise entre 0,05 et 1 mbar, puis un plasma à faible énergie, de préférence entre 0,05 et 0,5 W/cm², et de plus forte pression, par exemple entre 0,2 et 10 mbar.

Le gaz utilisé pour le plasma peut être de l'oxygène pur, soit de l'air, c'est-à-dire essentiellement un mélange oxygène-azote, soit encore un mélange d'oxygène et d'un gaz neutre, tel que de l'argon, de l'hélium ou du xénon. L'homme du métier comprendra que d'autres gaz oxydants peuvent également être utilisés.

Le plasma utilisé est typiquement un plasma radiofréquence.

Dans tous les cas, le traitement oxydant, et notamment le traitement par plasma oxydant, peut être effectué à température ambiante ou à chaud, par exemple à une température de l'ordre de 500°C.

Le traitement oxydant du système catalytique permet de modifier l'état d'oxydation du catalyseur métallique. On a pu mettre en évidence que, toutes choses étant égales par ailleurs, l'état oxydation du catalyseur conditionnait le type de croissance : un état oxydé conduit à une croissance rapide à partir de la base des nanotubes alors qu'un état non oxydé conduit à une croissance par le sommet des nanotubes. Ainsi, un catalyseur métallique oxydé privilégie la naissance de nouveaux nanotubes au niveau du substrat et permet par conséquent d'obtenir des densités surfaciques plus élevées. Les nanotubes obtenus peuvent être du type mono-feuillet (SWCNT) ou multi-feuillet (MWCNT).

Nous donnerons ci-après quelques exemples du procédé d'obtention de tapis de nanotubes de carbone selon l'invention.

### Exemple n° 1 : (ne faisant pas partie de l'invention)

Le substrat utilisé est du silicium monocristallin désoxydé par bombardement d'ions d'argon. Le système catalytique est constitué d'une couche de 1 nm de fer déposée sur le silicium désoxydé au moyen d'une pulvérisation de fer par faisceau d'ions (*Ion Beam Sputtering*) d'argon.

La couche de fer subit ensuite un traitement par plasma oxydant avec deux plasmas d'air successifs générés à température ambiante et à une pression de 0,4 mbar.

L'échantillon est disposé sur l'électrode reliée à la source RF.

Le premier plasma à énergie relativement élevée induit une tension d'autopolarisation de 120 V sur l'échantillon, ce qui permet de le bombarder tout en l'oxydant.

Le second plasma à énergie relativement plus faible induit une tension d'autopolarisation de 65 V.

Une fois le traitement oxydant terminé, l'échantillon est monté en température jusqu'à 560°C sous une pression partielle d'hydrogène de 0,2 mbar.

La croissance des nanotubes est obtenue en introduisant alors dans le réacteur un mélange gazeux composé d'acétylène, d'hélium et d'hydrogène avec des débits respectifs de 10 cm³ standard/min, 50 cm³ standard/min, 50 cm³ standard/min, pendant 1h à une pression de 0,24 mbar. La croissance est réalisée à une température de 560°C.

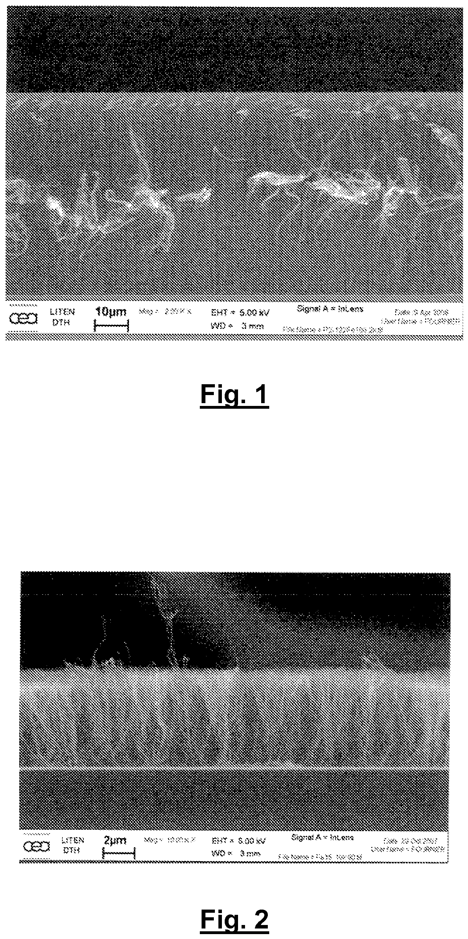

Dans ces conditions, on obtient un tapis de nanotubes de faible diamètre (5 nm), de longueur 60 µm et de densité 4.10¹¹ cm⁻², comme le montre le cliché SEM de la Figure 1.

La Figure 2 montre par comparaison un tapis de nanotubes obtenu dans les mêmes conditions que précédemment mais sans oxydation préalable de la couche de fer. Les nanotubes sont sensiblement plus courts (6 µm) et de plus fort diamètre (12 nm) que dans la Figure 1.

### Exemple n° 2 : (ne faisant pas partie de l'invention)

Cet exemple est identique au précédent à la différence du type de dépôt de la couche de fer. Après une gravure humide du silicium à l'acide fluorhydrique, le dépôt de la couche de fer est réalisé par évaporation à canon à électrons. La suite du procédé de croissance est identique à celui de l'exemple 1. Les résultats obtenus sont similaires aux précédents.

### Exemple n° 3 :

Le substrat utilisé est une couche de nitrure de titane TiN. Le système catalytique est ici constitué d'une couche de fer de 2 nm sur une couche de silicium amorphe de 5nm. La couche de silicium amorphe puis la couche de fer sont déposées au moyen d'une pulvérisation par faisceau d'ions au cours d'un même cycle de vide.

On procède ensuite, dans les mêmes conditions que celles de l'exemple 1, au traitement par plasma oxydant puis à la croissance des nanotubes.

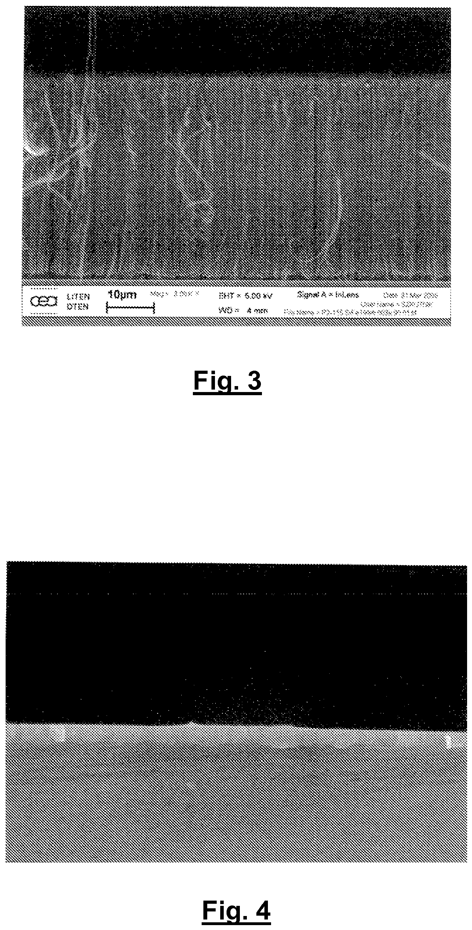

Dans ces conditions, on obtient un tapis dense de nanotubes sur TiN, de longueur 32 µm et de densité 2.10¹¹ cm⁻², comme illustré en Figure 3.

La Figure 4 montre par comparaison le cas où une simple couche de fer est déposée sur la couche TiN, sans traitement oxydant préalable. On constate alors l'absence de croissance de nanotubes sur cette couche.

Le procédé d'obtention de tapis de NTC selon l'invention peut être utilisé dans la réalisation d'éléments d'interconnexion, notamment de vias dans un circuit intégré.

Les Figures 5A à 5H montrent les différentes étapes de réalisation d'un élément d'interconnexion à l'aide du procédé selon l'invention.

On a représenté en Figure 5A un substrat conducteur ou semi-conducteur, 510, à partir duquel le via doit être réalisé. Comme on l'a déjà dit plus haut, ce substrat peut être une simple couche métallique, par exemple du Ti, Ta, W, Cu ou bien une couche semiconductrice, déposée sur un substrat massif non représenté. Le substrat 510 est recouvert d'une barrière de diffusion, 520, par exemple du nitrure de titane (TiN) ou de tantale (TaN). Le dépôt de la couche métallique et de la barrière de diffusion est effectué de manière connue en soi.

A l'étape suivante représentée en Figure 5B, une couche de silicium amorphe 530 est déposée sur la barrière de diffusion 520. L'épaisseur de la couche 530 peut être de l'ordre de 5 nm.

On dépose ensuite, comme indiqué en Figure 5C, une couche diélectrique 540, par exemple du Si0₂ ou du Si₃N4, sur la couche de silicium amorphe, puis une couche conductrice 550, par exemple une couche en TiN.

L'étape suivante illustrée en Figure 5D consiste à réaliser un masquage, de manière classique à l'aide d'un masque en photorésist, puis à graver le motif défini par le masque au moyen d'un procédé de gravure sèche. La gravure est arrêtée sur la couche de silicium amorphe 530.

On procède ensuite, en Figure 5E, à une gravure dans de l'acide fluorhydrique dilué, qui permet de désoxyder le silicium amorphe et de ne graver que latéralement les flancs 541 du via.

Immédiatement après cette gravure humide, on met l'échantillon sous vide et on dépose une couche métallique de fer, 570, 571 par exemple une couche de 2nm, au moyen d'une pulvérisation par faisceau d'ions sous incidence normale. La casquette formée par le masque et la directivité du faisceau préviennent un dépôt sur les flancs du via, comme illustré en Figure 5F.

En Figure 5G, on élimine ensuite la résine et par suite la partie, 571, de la couche de fer déposée sur celle-ci, puis on procède dans un même cycle de vide à l'étape d'oxydation, par un plasma ou par plusieurs plasmas successifs, à température ambiante.

On passe ensuite dans le même cycle de vide à l'étape de croissance des nanotubes. Pour ce faire, on monte en température l'échantillon et on introduit dans l'enceinte un mélange réactif, par exemple un mélange d'acétylène et d'hydrogène avec de l'hélium comme gaz vecteur. Le temps de croissance est déterminé de manière à ce que la longueur des nanotubes excède la profondeur du via. Le tapis de nanotubes est désigné par 580.

L'échantillon peut ensuite être poli mécaniquement de manière à ce que les nanotubes affleurent à la surface de la couche conductrice 550. Le cas échéant, un dépôt d'une nouvelle couche métallique est effectué de manière à améliorer le contact électrique entre les couches 520 et 550.

Selon une première variante, le procédé de réalisation du via débute, comme précédemment, par les étapes illustrées en Figures 5A à 5E. Il se poursuit ensuite par les étapes décrites ci-après.

En Figure 5F', c'est-à-dire après la gravure dans l'acide fluorhydrique dilué, on enlève le masque de résine, puis on dépose, comme indiqué en Figure 5G', une couche métallique de fer, par exemple une couche de fer de 1nm et on procède dans un même cycle de vide à l'étape d'oxydation.

On fait ensuite croître les nanotubes dans les mêmes conditions que précédemment. La croissance n'intervient que sur la couche de fer, 570, déposée au fond du via et non sur la couche supérieure, 571. En effet, sur une couche de TiN (ou TaN) seul le complexe catalytique constitué d'une couche métallique (fer) et d'une couche de silicium amorphe permet la croissance des nanotubes.

Le procédé de réalisation se termine comme précédemment par une étape de polissage mécanique dans laquelle on élimine la couche résiduelle supérieure, 571, et, le cas échéant, de dépôt d'une nouvelle couche conductrice.

Selon une variante ne faisant pas partie de l'invention, le procédé de réalisation du via, débute également par les étapes illustrées en Figures 5A à 5E à la différence près que le dépôt de silicium amorphe est omis.

La structure résultante, après gravure dans l'acide fluorhydrique dilué et élimination de la résine, est illustrée en Figure 5F". On notera qu'elle se distingue de celle illustrée en Figure 5F' par l'absence de la couche de silicium amorphe.

En Figure 5G", on dépose, dans un même cycle de vide, la couche de silicium amorphe, 530, puis la couche métallique, 570, composant le complexe catalytique.

En Figure 5I", on effectue un polissage mécano-chimique de l'échantillon de manière à éliminer les couches résiduelles de métal 571 et de silicium amorphe 531. On procède ensuite à l'étape d'oxydation du complexe catalytique.

L'étape de croissance des nanotubes illustrée en Figure 5I" est identique à celle de la Figure 5H.

## Revendications

1. Procédé d'obtention d'un tapis de nanotubes de carbone sur un substrat conducteur ou semi-conducteur (510), **caractérisé en ce qu'**il comprend les étapes suivantes :
- dépôt d'un complexe catalytique (520, 570), comprenant au moins une couche métallique (570), sur ledit substrat, la couche métallique (570) étant composée de fer et déposée sur une couche de silicium amorphe (530), la couche de silicium amorphe étant déposée sur le substrat (510), le substrat étant du nitrure de titane ou du nitrure de tantale ;
- traitement oxydant de ladite couche métallique (570) au moyen d'un plasma ou d'une succession de plasmas;
- croissance de nanotubes de carbone (580) à partir de la couche métallique ainsi oxydée.

2. Procédé d'obtention selon la revendication 1, **caractérisé en ce que** le traitement oxydant comprend une première étape d'oxydation à l'aide d'un premier plasma à une première énergie et une première pression et une seconde étape d'oxydation à l'aide d'un second plasma à une seconde énergie plus faible que ladite première énergie et à une seconde pression plus élevée que ladite première pression.

3. Procédé d'obtention selon la revendication 1 ou 2, **caractérisé en ce que** l'oxydation par plasma est effectuée à température ambiante.

4. Procédé de réalisation d'un via destiné à interconnecter une première et une seconde couches conductrices (510, 550), **caractérisé en ce qu'**il comprend les étapes suivantes :
- dépôt d'une barrière de diffusion (520) sur la première couche conductrice (510);
- formation d'un complexe catalytique comprenant une première couche de silicium amorphe (530) et une couche métallique (570) composée de fer sur la barrière de diffusion (520), au fond du via ;
- traitement oxydant de ladite couche métallique (570) au moyen d'un plasma ou d'une succession de plasmas ;
- croissance de nanotubes de carbone (580) à partir de la couche métallique ainsi oxydée, le temps de croissance étant déterminé de manière à ce que la longueur des nanotubes soit supérieure à la profondeur du via.

5. Procédé de réalisation d'un via selon la revendication 4, **caractérisé en ce qu'**il comprend les étapes suivantes :
- dépôt de la couche de silicium amorphe (530) sur la barrière de diffusion (520) ;
- dépôt d'une couche diélectrique (540) sur la couche de silicium amorphe, puis dépôt de la seconde couche conductrice (550) sur la couche diélectrique ;
- dépôt d'un masque de gravure (560) et gravure d'un trou de via jusqu'à la couche de silicium amorphe (530).

6. Procédé de réalisation d'un via selon la revendication 5, **caractérisé en ce que** l'étape de gravure du trou de via est suivie d'un dépôt de la couche métallique (570) et d'une élimination du masque (560), le complexe catalytique étant ainsi localisé au fond du trou de via.

7. Procédé de réalisation d'un via selon la revendication 5, **caractérisé en ce que** l'étape de gravure du trou de via est suivie d'une élimination du masque (560) et d'un dépôt de la couche métallique (570), le complexe catalytique étant ainsi localisé au fond du trou de via et la seconde couche conductrice (550) étant recouverte de ladite couche métallique (571).

8. Procédé de réalisation d'un via selon la revendication 4, **caractérisé en ce qu'**il comprend les étapes suivantes :
- dépôt d'une couche diélectrique (540) sur la barrière de diffusion (520), puis dépôt de la seconde couche conductrice (550) sur la couche diélectrique ;
- dépôt d'un masque de gravure (560), gravure d'un trou de via jusqu'à la couche de silicium amorphe (530) et élimination du masque ;
- dépôt de la couche métallique (570), puis polissage mécano-chimique de manière à éliminer le complexe catalytique présent sur la seconde couche conductrice, le complexe catalytique étant ainsi localisé au fond du trou de via.

9. Procédé de réalisation d'un via selon l'une des revendications 4 à 8, **caractérisé en ce que** le dépôt de la couche métallique est réalisé au moyen d'une pulvérisation par faisceau d'ions.

10. Procédé de réalisation d'un via selon l'une des revendications 4 à 9, **caractérisé en ce que** le traitement oxydant par plasma ou succession de plasmas est réalisé à température ambiante.

## Patentansprüche

1. Verfahren zum Herstellen einer Matte aus Kohlenstoffnanoröhrchen auf einem Leiter- oder Halbleitersubstrat (510),
**dadurch gekennzeichnet, dass** es die nachstehenden Schritte umfasst:
- Abscheiden von einem zumindest eine Metallschicht (570) enthaltenden katalytischen Komplex (520, 570) auf das Substrat, wobei die Metallschicht (570) aus Eisen besteht und auf eine Schicht aus amorphem Silizium (530) abgeschieden ist, wobei die Schicht aus amorphem Silizium auf das Substrat (510) abgeschieden ist, wobei das Substrat Titannitrid oder Tantalnitrid ist;
- Oxidationsbehandlung der Metallschicht (570) mittels eines Plasmas oder einer Folge von Plasmen;
- Wachstum von Kohlenstoffnanoröhrchen (580) ausgehend von der so oxidierten Metallschicht.

2. Herstellungsverfahren nach Anspruch 1, **dadurch gekennzeichnet, dass** die Oxidationsbehandlung einen ersten Oxidationsschritt unter Verwendung eines ersten Plasmas mit einer ersten Energie und einem ersten Druck und einen zweiten Oxidationsschritt unter Verwendung eines zweiten Plasmas mit einer zweiten Energie, die niedriger als die erste Energie ist, und mit einem zweiten Druck, der höher als der erste Druck ist, umfasst.

3. Herstellungsverfahren nach Anspruch 1 oder 2, **dadurch gekennzeichnet, dass** die Plasmaoxidation bei Raumtemperatur erfolgt.

4. Verfahren zum Herstellen einer Durchkontaktierung zum Verbinden einer ersten und einer zweiten leitfähigen Schicht (510, 550), **dadurch gekennzeichnet, dass** es die folgenden Schritte umfasst:
- Abscheiden einer Diffusionsbarriere (520) auf die erste leitfähige Schicht (510);
- Bilden von einem katalytischen Komplex, der eine erste Schicht aus amorphem Silizium (530) und eine Metallschicht (570) aus Eisen enthält, auf die Diffusionsbarriere (520) am Grund der Durchkontaktierung;
- Oxidationsbehandlung der Metallschicht (570) mittels eines Plasmas oder einer Folge von Plasmen;
- Wachstum von Kohlenstoffnanoröhrchen (580) ausgehend von der so oxidierten Metallschicht, wobei die Wachstumszeit so bestimmt ist, dass die Länge der Nanoröhrchen größer als die Tiefe der Durchkontaktierung ist.

5. Verfahren zum Herstellen einer Durchkontaktierung nach Anspruch 4, **dadurch gekennzeichnet, dass** es die folgenden Schritte umfasst:
- Abscheiden der Schicht aus amorphem Silizium (530) auf die Diffusionsbarriere (520);
- Abscheiden einer dielektrischen Schicht (540) auf die Schicht aus amorphem Silizium, dann Abscheiden der zweiten leitfähigen Schicht (550) auf die dielektrische Schicht;
- Abscheiden einer Ätzmaske (560) und Ätzen eines Durchgangslochs bis zur Schicht aus amorphem Silizium (530).

6. Verfahren zum Herstellen einer Durchkontaktierung nach Anspruch 5, **dadurch gekennzeichnet, dass** auf den Schritt des Ätzens des Durchgangslochs ein Abscheiden der Metallschicht (570) und ein Entfernen der Maske (560) folgen, wobei sich der katalytische Komplex somit am Grund des Durchgangslochs befindet.

7. Verfahren zum Herstellen einer Durchkontaktierung nach Anspruch 5, **dadurch gekennzeichnet, dass** auf den Schritt des Ätzens des Durchgangslochs ein Entfernen der Maske (560) und ein Abscheiden der Metallschicht (570) folgen, wobei sich der katalytische Komplex somit am Grund des Durchgangslochs befindet und die zweite leitfähige Schicht (550) mit der Metallschicht (571) bedeckt ist.

8. Verfahren zum Herstellen einer Durchkontaktierung nach Anspruch 4, **dadurch gekennzeichnet, dass** es die nachfolgenden Schritte umfasst:
- Abscheiden einer dielektrischen Schicht (540) auf die Diffusionsbarriere (520), dann Abscheiden der zweiten leitfähigen Schicht (550) auf die dielektrische Schicht;
- Abscheiden einer Ätzmaske (560), Ätzen eines Durchgangslochs bis zur Schicht aus amorphem Silizium (530) und Entfernen der Maske;
- Abscheiden der Metallschicht (570), dann mechanisch-chemisches Polieren, so dass der an der zweiten leitfähigen Schicht vorhandene katalytische Komplex entfernt wird, wobei sich der katalytische Komplex somit am Grund des Durchgangslochs befindet.

9. Verfahren zum Herstellen einer Durchkontaktierung nach einem der Ansprüche 4 bis 8, **dadurch gekennzeichnet, dass** das Abscheiden der Metallschicht durch Ionenstrahlsputtern erfolgt.

10. Verfahren zum Herstellen einer Durchkontaktierung nach einem der Ansprüche 4 bis 9, **dadurch gekennzeichnet, dass** die Oxidationsbehandlung durch Plasma oder durch eine Folge von Plasmen bei Raumtemperatur erfolgt.

## Claims

1. Process for producing a mat of carbon nanotubes on a conductive or semiconductor substrate (510), **characterized in that** it comprises the following steps:
- deposition of a catalytic complex (520,570), comprising at least one metal layer (570), on said substrate, the metal layer (570) being made up of iron and deposited on an amorphous silicon layer (530), the amorphous silicon layer being deposited on the substrate (510), the substrate being made of titanium nitride or tantalum nitride;
- oxidizing treatment of said metal layer (570) by means of a plasma or a succession of plasma; and
- growth of carbon nanotubes (580) starting from the metal layer thus oxidized.

2. Production process according to Claim 1, **characterized in that** the oxidizing treatment comprises a first oxidation step using a first plasma with a first energy at a first pressure and a second oxidation step using a second plasma with a second energy, lower than said first energy, and at a second pressure higher than said first pressure.

3. Production process according to Claim 1 or 2, **characterized in that** the plasma-induced oxidation is carried out at room temperature.

4. Process for producing a via intended for interconnecting first and second conducting layers (510, 550), **characterized in that** it comprises the following steps:
- deposition of a diffusion barrier (520) on the first conductive layer (510);
- formation of a catalytic complex, comprising a first amorphous silicon layer (530) and a metal layer (570) made up of iron on the diffusion barrier (520), at the bottom of the via;
- oxidizing treatment of said metal layer (570) by means of a plasma or a succession of plasma; and
- growth of carbon nanotubes (580) starting from the metal layer thus oxidized, the growth time being determined so that the length of the nanotubes is greater than the depth of the via.

5. Process for producing a via according to Claim 4 , **characterized in that** it comprises the following steps:
- deposition of the amorphous silicon layer (530) on the diffusion barrier (520);
- deposition of a dielectric layer (540) on the amorphous silicon layer followed by deposition of the second conductive layer (550) on the dielectric layer; and
- deposition of an etch mask (560) and etching of a via hole down to the amorphous silicon layer (530).

6. Process for producing a via according to Claim 5, **characterized in that** the step of etching the via hole is followed by deposition of the metal layer (570) and removal of the mask (560), the catalytic complex thus being localized at the bottom of the via hole.

7. Process for producing a via according to Claim 5, **characterized in that** the step of etching the via hole is followed by removal of the mask (560) and deposition of the metal layer (570), the catalytic complex thus being localized at the bottom of the via hole and the second conductive layer (550) being covered with said metal layer (571).

8. Process for producing a via according to Claim 4, **characterized in that** it comprises the following steps:
- deposition of a dielectric layer (540) on the diffusion barrier (520) followed by deposition of the second conductive layer (550) on the dielectric layer;
- deposition of an etch mask (560), etching of a via hole down to the amorphous silicon layer (530) and removal of the mask; and
- deposition of the metal layer (570), followed by chemical-mechanical polishing so as to remove the catalytic complex present on the second conductive layer, the catalytic complex thus being localized at the bottom of the via hole.

9. Process for producing a via according to one of Claims 4 to 8, **characterized in that** the metal layer is deposited by means of ion beam sputtering.

10. Process for producing a via according to one of Claims 4 to 9, **characterized in that** the oxidizing treatment by a plasma or by a succession of plasma is carried out at room temperature.
